# EUROPÄISCHE PATENTSCHRIFT

(11) **EP 1 862 047 B1**
(45) Veröffentlichungstag und Bekanntmachung des Hinweises auf die Patenterteilung: **19.12.2012**
(21) Anmeldenummer: 06707189.4
(22) Anmeldetag: 22.02.2006
(51) Int. Cl.: H05K 13/04

(54) **ANTRIEBSEINHEIT FÜR EIN BEWEGBARES FUNKTIONSELEMENT**
DRIVE UNIT FOR A DISPLACEABLE FUNCTIONAL ELEMENT
UNITE D'ENTRAINEMENT POUR ELEMENT FONCTIONNEL MOBILE

(30) Priorität: 24.02.2005 DE 102005008584
(43) Veröffentlichungstag der Anmeldung: 05.12.2007
(73) Patentinhaber: AeroLas GmbH Aerostatische Lager-Lasertechnik, 82008 Unterhaching (DE)
(72) Erfinder: MUTH, Michael, 81737 München (DE); SLOTTA, Georg, 85375 Neufahrn (DE); BRAND, Jan, 81539 München (DE)
(74) Vertreter: Schlimme, Wolfram
(86) Internationale Anmeldenummer: PCT/EP2006/001628
(87) Internationale Veröffentlichungsnummer: WO 2006/089742

(56) Entgegenhaltungen:
- US-A- 5 758 410
- US-A- 6 012 222
- US-A1- 2002 116 090
- US-B1- 6 240 628

## Beschreibung

Die Erfindung bezieht sich auf eine Antriebseinheit für zumindest ein bewegbares Funktionselement, insbesondere auf einen Bestückkopf zum Handhaben von elektrischen Bauelementen, mit zumindest einem um eine feste Achse drehbaren und entlang der Achse linear verschiebbaren Halter für das Funktionselement, wobei die Antriebseinheit einen Drehantrieb und einen Linearantrieb für den Halter aufweist.

Eine derartige als Bestückkopf für elektrische Bauelemente ausgebildete Antriebseinheit ist z. B. durch die US 6,240,628 B bekannt geworden. Danach weist der spindelartige Halter an seinem unteren Ende einen Ansatz zum Befestigen einer auswechselbaren Saugpipette für ein elektrisches Bauelement auf. Darüber ist ein Linearantrieb in Form einer Tauchmagnetspule angeordnet, deren Permanentmagnet unmittelbar am Halter und deren Spule an einem Gehäuse des x-y-verschiebbaren Bestückkopfes mitdrehend befestigt ist. Ferner ist am oberen Ende des Halters ein Drehantrieb in Form eines Zahnriemenantriebs angeordnet, der mit seiner Riemenspannung unmittelbar seitlich auf den Halter einwirkt. Auch zwischen dem Permanentmagneten und der Spule wirken seitliche Magnetkräfte, die die Achslage des Halters zumindest im elastischen Bereich beeinflussen.

Die US 2002/0116090 A1 offenbart einen Bestückkopf mit einer Antriebseinheit mit einem Drehantrieb und einem Linearantrieb. Diese Antriebseinheit ist an ihrer Unterseite mit dem Bestückkopf versehen. Dieser Bestückkopf weist einen oberen Körperabschnitt und einen unteren Körperabschnitt auf. Der obere Körperabschnitt ist vom unteren Körperabschnitt mittels eines in Axialrichtung wirkenden Luftlagers getrennt, wobei der untere Körperabschnitt gegen die Kraft des Luftlagers von einer Wendelfeder an den oberen Körperabschnitt gezogen wird. Dieses Luftlager dient dazu, ein nahezu reibungsfreies Lager zwischen dem oberen Körperabschnitt und dem unteren Körperabschnitt zu bilden, wenn durch Unterdrucksetzen des Luftlagers der untere Körperabschnitt vom oberen Körperabschnitt abgehoben wird. Die Wendelfeder dient nicht nur dazu, den unteren Körperabschnitt an den oberen Körperabschnitt gegen die Lagerkraft anzuziehen, sondern auch dazu, den unteren Körperabschnitt koaxial mit dem oberen Körperabschnitt zu zentrieren wenn das Luftlager unter Druck gesetzt wird. Im Falle einer Entkopplung des unteren Körperabschnitts vom oberen Körperabschnitt ist weder eine kinematisch feste Kopplung zwischen dem Drehantrieb und dem am unteren Körperabschnitt vorgesehenen Halter, noch eine kinematisch feste Kopplung des Linearantriebs mit dem Halter vorgesehen, da der untere Körperabschnitt durch das im Luftlager gebildete Luftpolster vom oberen Körperabschnitt abgehoben wird. Eine Entkopplung des unteren Körperabschnitts vom oberen Körperabschnitt durch Unterdrucksetzen des Luftlagers bewirkt sowohl eine Entkopplung des Drehantriebs, als auch eine Entkopplung des Linearantriebs in ihrer jeweiligen Antriebsrichtung vom Halter, sowie auch eine Entkopplung im Hinblick auf die Achslage des Halters.

Die US 6,012,222 A offenbart einen Bestückungskopf mit einem Halter, der mit einem Linearantrieb in Richtung der Achse des Halters fest gekoppelt ist, sowie einen Drehantrieb, der in Richtung der Drehachse mit dem Halter fest gekoppelt ist. Eine Kupplung zwischen dem Drehantrieb und dem Halter nicht vorhanden.

Der Erfindung liegt die Aufgabe zugrunde, die Herstellung der Antriebseinheit zu erleichtern und deren Funktionsfähigkeit zu verbessern.

Diese Aufgabe wird durch die im Kennzeichen des Anspruchs 1 angegebenen Merkmale gelöst. Das Funktionselement kann z.B. als unmittelbar an den Halter angesetztes Werkstück, als Greifer für ein solches Werkstück oder als Bearbeitungswerkzeug z.B. in Form eines Bohrers ausgebildet sein. Insbesondere bei unmittelbar von einem Wafer entnommenen Bauelementen können die Genauigkeitsanforderungen an die Position des Halters sowohl beim Abholen, Verdrehen und Aufsetzen des Bauelementes sehr hoch sein. Durch die beanspruchte Kopplung des Halters mit den Antrieben lediglich in der Antriebsrichtung und durch die Entkoppelung von die Achslage beeinflussenden Kräften kann der Halter weitgehend kraftfrei, reibungs- und verschleißarm und lagegenau im Gehäuse geführt werden. Dazu ist der Halter mit beweglichen Teilen des Linearantriebs quer zur Achse nachgiebig und in Antriebsrichtung kinematisch fest gekoppelt, so dass der Halter mit dem Linearantrieb zur Übertragung einer Axialbewegung gekoppelt und im Hinblick auf die Achslage entkoppelt ist. Der Halter ist weiterhin mit beweglichen Teilen des Drehantriebs quer zur Achse nachgiebig und in Antriebsrichtung kinematisch fest gekoppelt, so dass der Halter mit dem Drehantrieb zur Übertragung einer Drehbewegung gekoppelt und im Hinblick auf die Achslage entkoppelt ist.

Die Entkopplung erfordert zudem eine weniger genaue Zuordnung, wodurch sich die Herstellung der Antriebseinheit vereinfacht. Lageabweichungen zwischen den Antrieben und dem Halter verursachen keine Verspannungen und Verkantungen, so dass die Führungen entsprechend entlastet werden und eine längere Lebensdauer versprechen. Es versteht sich, dass mehrere der nebeneinanderliegenden Antriebseinheiten zu einer Vielfachvorrichtung zusammengefasst werden können.

Vorteilhafte Weiterbildungen der Erfindung ergeben sich aus den in den Ansprüchen 2 bis 12 gekennzeichneten Merkmalen.

Vorzugsweise sind z.B. die elektrisch aktiven Spulenteile der Antriebe stationär angeordnet und an festliegende Leitungen angeschlossen.

Der Stößel nach Anspruch 3 stellt ein einfaches Entkopplungs- und Übertragungselement dar, wobei durch das Drehlager ein Mitdrehen der beweglichen Teile des Linearantriebs vermieden wird und ein z.B. optischer Tastkopf einer zugeordnete Messeinrichtung für die lineare Hubbewegung stationär angeordnet werden kann.

Die in ihrer Wirkung einem Kardangelenk ähnliche Kupplung nach Anspruch 4 ermöglicht die unmittelbare sichere und spielfreie Übertragung der Drehbewegung des vorzugsweise als Elektromotor ausgebildeten Drehantriebs auf den Halter. Ein Seiten- oder Winkelversatz zwischen den Achsen bleibt dabei weitgehend ohne Einfluss auf die Stellung der Halterachse.

Der Gleitschuh nach Anspruch 5 stellt ein einfaches Übertragungselement dar, das sich durch die federnd kippbare Lagerung selbsttätig an der Lauffläche ausrichtet, so dass der Halter mit dem Drehantrieb in Bezug auf die Übertragung der Drehbewegung spielfrei gekoppelt, im Hinblick auf die anderen Freiheitsgrade aber entkoppelt ist.

Die aerostatische Drucklagerung nach Anspruch 6 ermöglicht eine verschleißfreie und präzise Wirkverbindung zwischen dem Halter und dem Mitnehmer, wobei als Druckmedium auch andere Gase als Luft zu Einsatz kommen können. Die magnetische Anziehungskraft zwischen dem Gleitschuh und der Klaue ergibt unter dem entgegenwirkenden Gasdruck eine genau parallele Ausrichtung Lagerfläche und der Lauffläche mit einem definierten Luftspalt, so dass die Drehstellung der Antriebswelle spielfrei auf den Halter übertragen werden kann. Eine solche Kupplung eignet sich besonders für die Übertragung von geringen Drehmomenten z.B. bei der Drehpositionierung von Montageteilen oder bei einem hochdrehenden Bearbeitungswerkzeug, z.B. zum Bohren von Leiterplatten.

Der drahtartige Stab und der Stift nach Anspruch 7 fixieren den Gleitschuh nachgiebig in seiner Groblage. Der Stab weist einen längeren ungeführten Abschnitt auf, so dass sich der Gleitschuh unter der Magnetkraft vollflächig an die Lauffläche anpassen kann. Der kurze Stift überträgt das Drehmoment des Drehantriebs auf den Gleitschuh und ist geringfügig verformbar, um eine geringe Winkelabweichung in der Achsrichtung zwischen der Gleitfläche und der Gegenfläche des Gleitschuhs auszugleichen. Eine derartige Kupplung bedarf daher keiner hohen Fertigungs- und Montagegenauigkeit.

Die Anordnung nach Anspruch 8 ermöglicht eine weitgehende Entflechtung der Antriebe voneinander und einen einfachen Aufbau der Antriebseinheit.

Die aerostatische Lagerung nach Anspruch 9 ermöglicht die reibungs- und verschleißfreie Führung des Halters unmittelbar im Gehäuse der Antriebseinheit. Es ist dabei von besonderem Vorteil, dass jede Veränderung der Dreh- oder Hubstellung hysteresefrei erfolgt, was die präzise Übertragung der Antriebsbewegungen auf den Halter ermöglicht. Eine derartige leichtgängige und präzise betätigbare Antriebseinheit eignet sich auch zum Handhaben von sehr empfindlichen und kleinen Bauelementen, z.B. von Chips eines Wafers.

Der hohle Stößel nach Anspruch 10 stellt eine einfache pneumatische Verbindung zum Halter dar.

Der z.B. luftgelagerte Kolben nach Anspruch 11 kann sehr kompakt und leicht ausgebildet sein, so dass seine ungefederte Masse entsprechend gering ist, wobei der Faltenbalg als axial nachgiebiges, drehsteifes Kupplungs- und Federelement dient. Dabei ist es möglich, den Raum zwischen dem Halter und dem Sauggreifer zur veränderbaren Einstellung der Aufsetzkraft an eine eigene pneumatische Leitung mit einem Druckregler anzuschließen. Es ist auch möglich, das Bauelement nicht unmittelbar mit dem Sauggreifer zu halten, sondern an dessen freies Ende ein Adapterstück für unterschiedliche Bauelementtypen auswechselbar anzusetzen.

Das Saugrohr nach Anspruch 12 kann vom Stößelende bis in die Nähe des freien Endes des hohlen Sauggreifers mit gleichbleibend geringem Querschnitt geführt werden, um die pneumatische Reaktion zu beschleunigen.

Ein Ausführungsbeispiel der Erfindung ist in der Zeichnung dargestellt und wird im folgenden näher erläutert. Es zeigen:
- **Fig. 1**: einen senkrechten Längsschnitt durch eine Antriebseinheit mit einem Gehäuse,
- **Fig. 2**: einen anderen Längsschnitt durch einen Teil der Antriebseinheit nach Figur 1 ohne das Gehäuse,
- **Fig. 3**: eine vergrößerte perspektivische Ansicht der Teile nach Figur 2,

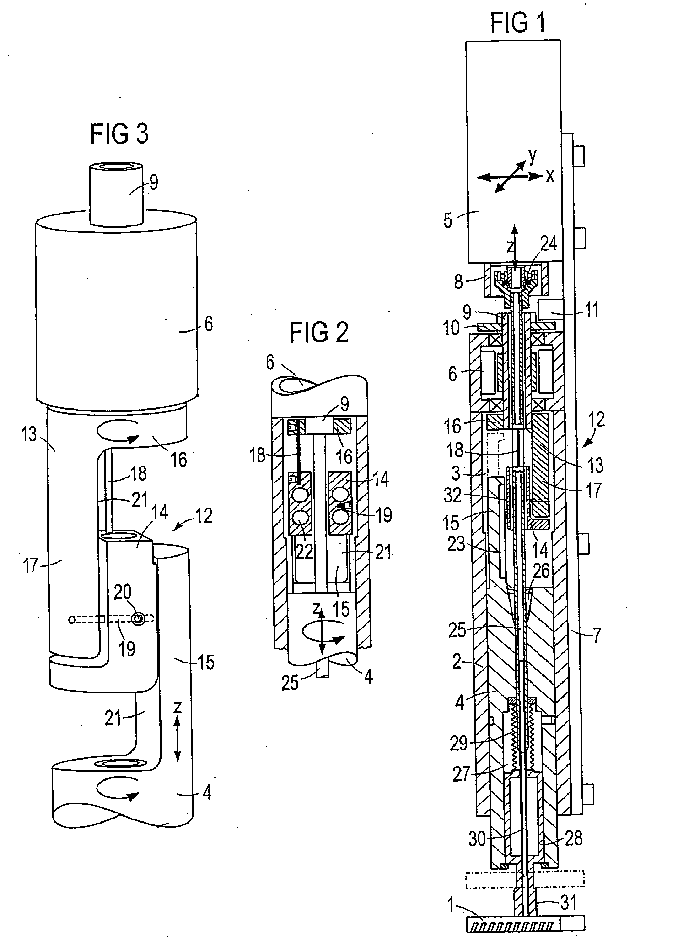

Nach den Figuren 1, 2 und 3 ist ein in einer x-y-Ebene verschiebbarer Bestückkopf zum Handhaben von elektrischen Bauelementen 1 mit einer Antriebseinheit versehen, die ein Gehäuse 2 mit einer Bohrung 3 zur Aufnahme eines Halters 4 für das Bauelement 1, einen Linearantrieb 5 und einen Drehantrieb 6 aufweist. Die Bohrung 3 erstreckt sich senkrecht zur x-y-Ebene in einer z-Richtung und führt den im wesentlichen zylindrischen, axial verschiebbaren und drehbaren Halter 4, der in einer unteren Hubstellung dargestellt ist. Es ist ohne weiteres möglich, mehrere der Antriebseinheiten für die gleichzeitige Aufnahme von mehreren der Bauelemente 1 mit mehreren der achsparallelen Bohrungen 3 in einem oder mehreren der Gehäuse 2 zusammenzufassen.

Der Halter 4 wird durch den Linearantrieb 5 in Form eines elektrischen Linearmotors und durch den Drehantrieb 6 in Form eines Elektromotors betätigt, der auf einer Oberseite des Gehäuses 2 über der Bohrung 3 annähernd koaxial mit dieser befestigt ist. Der Linearantrieb 5 befindet sich oberhalb des Drehantriebs 6 und ist mit seinem Stationärteil, fest mit dem Gehäuse 2 durch einen plattenartigen senkrechten Träger 7 verbunden.

Ein dem Drehantrieb 6 zugewandter Läufer 8 des Linearantriebs 5 ist in der z-Richtung verschiebbar und annähernd koaxial mit dem Drehantrieb 6 angeordnet. Dieser weist eine drehbare hohle Antriebswelle 9 auf, auf deren Oberseite zur Überwachung ihrer Drehlage eine Encoderscheibe 10 angebracht ist, die mittels eines am Träger 7 befestigten Lesekopfs 11 optisch abgetastet werden kann. Auf der gegenüberliegenden Seite des Drehantriebs 6 ist die Antriebswelle 9 mit dem im Gehäuse 2 luftgelagerten Halter 4 über eine Kupplung 12 verbunden, die aus einem Mitnehmer 13, einem Gleitschuh 14 und einer seitlichen Klaue 15 des Halters 4 gebildet ist.

Der Mitnehmer 13 ist mit einer scheibenartigen Muffe 16 auf der Antriebswelle 9 befestigt und ragt von dort mit einem segmentartigen Schenkel 17 in die Richtung des Halters 4. Der Gleitschuh 14 ist mittels eines zur Drehachse parallelen biegsamen und tordierbaren Stabes 18 und eines zur Drehachse senkrechten Stiftes 19 am Mitnehmer 13 abgestützt ist, der fest mit der Antriebswelle 9 des Drehantriebs 6 verbunden ist. Der drahtartige Stab 18 und der Stift 19 fixieren den Gleitschuh 14 kardanartig nachgiebig in seiner Groblage. Der Stab 18 weist einen längeren ungeführten Abschnitt auf. Der kurze, mittels einer Schraube 20 am Gleitschuh 14 einstellbar festgeklemmte Stift 19 überträgt das Drehmoment des Drehantriebs 5 auf den Gleitschuh 14 und ist geringfügig verformbar. Die Klaue 15 weist eine achsparallele flache Lauffläche 21 auf, der eine entsprechende Lagerfläche 32 des Gleitschuhs 14 mit einem schmalen definierten Luftlagerspalt gegenüberliegt. Der Gleitschuh 14 ist mit Permanentmagneten 22 versehen, die ihn gegen ein eingesetztes Eisenblech 23 der Klaue 15 und gegen den im Spalt herrschenden Luftdruck spannen. Durch die Nachgiebigkeit des Stabs 18 und des Stifts 19 stellt sich die Lagerfläche 32 des Gleitschuhs 14 zur Lauffläche 21 genau parallel, so dass der Gleitschuh 14 relativ zur Klaue 15 ohne Lagerspiel axial verschiebbar ist. Auf diese Weise wird die Drehstellung der Antriebswelle 9 exakt auf den Halter 4 übertragen, ohne dass deren beide Drehachsen genau übereinstimmen müssen.

Der nicht drehbare Läufer 8 des Linearantriebs 5 ist über ein Drehlager 24 mit einem Stößel 25 verbunden, der aus einem dünnen Rohr gebildet ist, das mit Spiel durch die hohle Antriebswelle 9 und den Gleitschuh 14 hindurch bis in den Halter 4 ragt, an dem er mittels einer Klemmverbindung 26 in der Art eines Spannkonus verankert ist. Der Querschnitt des schlanken Stößel 25 ist hinreichend groß, um die aus der Hubbeschleunigung des Halters 4 resultierende Massenkraft sicher zu übertragen. Die in der z-Richtung ausgeübte Hubbewegung des Läufers 8 wird dabei spielfrei auf den Halter 4 übertragen. Der. schlanke, bis zum Halter 4 ungeführte Stößel 25 ist seitlich derart nachgiebig, dass er Lageabweichungen der Halterachse von der Läuferachse vollständig ausgleicht.

Der Halter 4 weist an seinem unteren Ende eine koaxiale Zylinderbohrung 27 auf, in die längsverschiebbar ein als leichter Hohlkörper ausgebildeter luftgelagerter Kolben 28 in Form eines Sauggreifers für das Bauelement 1 eingesetzt ist, das an das verjüngte untere Ende des Kolbens 28 unmittelbar angesaugt ist. Dieses untere Ende weist eine zylindrische Passfläche 31 zum wahlweisen und wechselbaren Ansetzen von Adapterstücken auf, die der Anpassung an unterschiedliche Bauelementetypen dienen. Auf der Oberseite des Sauggreifers ist ein Faltenbalg 29 angesetzt, der sich unter geringer Vorspannung am Halter 4 abstützt und in den der unterste Abschnitt des stößels 25 hineinragt.

Durch den Kolben 28 hindurch ist bis in die Nähe seines unteren Saugendes ein dünnes Saugrohr 30 eingesetzt, das mit seinem oberen Endabschnitt in den hohlen Stößel 25 axial verschiebbar hineinragt. Der Stößel 25 ist an seinem oberen Ende an eine schaltbare pneumatische Leitung angeschlossen, durch die das untere Saugende des Kolbens 28 über das Saugrohr 30 und den Stößel 25 mit Saugluft verbunden werden kann, um das Bauelement 1 an einer Abholstelle sicher ansaugen, anheben, in der x-y-Ebene zu seiner Aufsetzstelle verfahren und auf ein Substrat in der z-Richtung absenken zu können, wobei der Sauggreifer nach dem Aufsetzen in den Halter 4 einfedern kann. Die Zylinderbohrung 27 ist an eine druckregelbare Pneumatikleitung angeschlossen, um unterschiedliche Aufsetzkräfte für das Bauelement einstellen zu können. Der seitlich auslenkbare Faltenbalg 29 dient sowohl der Abdichtung des Saugrohrs als auch der spielfreien Drehsicherung des Sauggreifers 28 gegenüber dem Halter 4.

Die in dieser Anmeldung als Luftlager bezeichneten aerostatischen Lager können statt mit Luft auch mit anderen geeigneten Druckgasen versorgt werden.

Die Erfindung ist nicht auf das obige Ausführungsbeispiel beschränkt, das lediglich der allgemeinen Erläuterung des Kerngedankens der Erfindung dient. Im Rahmen des Schutzumfangs kann die erfindungsgemäße Vorrichtung vielmehr auch andere als die oben beschriebenen Ausgestaltungsformen annehmen.

Bezugszeichen in den Ansprüchen, der Beschreibung und den Zeichnungen dienen lediglich dem besseren Verständnis der Erfindung und sollen den Schutzumfang nicht einschränken.

### Bezugszeichen

- 1: Bauelement
- 2: Gehäuse
- 3: Bohrung
- 4: Halter
- 5: Linearantrieb
- 6: Drehantrieb
- 7: Träger
- 8: Läufer
- 9: Antriebswelle
- 10: Encoderscheibe
- 11: Lesekopf
- 12: Kupplung
- 13: Mitnehmer
- 14: Gleitschuh
- 15: Klaue
- 16: Muffe
- 17: Schenkel
- 18: Stab
- 19: Stift
- 20: Schraube
- 21: Lauffläche
- 22: Permanentmagnet
- 23: Eisenblech
- 24: Drehlager
- 25: Stößel
- 26: Klemmverbindung
- 27: Zylinderbohrung
- 28: Kolben
- 29: Faltenbalg
- 30: Saugrohr
- 31: Passfläche
- 32: Lagerfläche

## Patentansprüche

1. Antriebseinheit für zumindest ein bewegbares Funktionselement, insbesondere Bestückkopf zum Handhaben eines z.B. als elektrisches Bauelement (1) ausgebildeten Elements, mit zumindest einem um eine Achse drehbaren und entlang der Achse linear verschiebbaren Halter (4) für das Funktionselement, wobei die Antriebseinheit einen Drehantrieb (6) und einen Linearantrieb (5) für den Halter (4) aufweist,
wobei
- der Halter (4) mit beweglichen Teilen des Linearantriebs (5) quer zur Achse nachgiebig und in Antriebsrichtung kinematisch fest gekoppelt ist, so dass der Halter (4) mit dem Linearantrieb (5) zur Übertragung einer Axialbewegung gekoppelt und im Hinblick auf die Achslage entkoppelt ist und
- der Halter (4) mit beweglichen Teilen des Drehantriebs (6) quer zur Achse nachgiebig und in Antriebsrichtung kinematisch fest gekoppelt ist, so dass der Halter (4) mit dem Drehantrieb (6) zur Übertragung einer Drehbewegung gekoppelt und im Hinblick auf die Achslage entkoppelt ist.

2. Antriebseinheit nach Anspruch 1,
**dadurch gekennzeichnet,**
**dass** stationäre Teile des Drehantriebs (6) und des Linearantriebs (5) fest mit einem Gehäuse (2) der Betätigungseinrichtung verbunden sind.

3. Antriebseinheit nach Anspruch 2,
**dadurch gekennzeichnet,**
**dass** der Linearantrieb (5) über einen sich in der Achsrichtung (z) erstreckenden biegsamen Stößel (25) mit dem Halter (4) gekoppelt ist und dass der Linearantrieb (5) mit dem Stößel (25) über ein Drehlager (24) gekoppelt ist.

4. Antriebseinheit nach Anspruch 2 oder 3,
**dadurch gekennzeichnet,**
**dass** der Drehantrieb (6) über eine Kupplung (12) mit dem Halter (4) gekoppelt ist.

5. Antriebseinheit nach Anspruch 4,
**dadurch gekennzeichnet,**
**dass** die Kupplung (12) einen bezüglich der Drehachse federnd kippbar abgestützten Gleitschuh (14) aufweist, der an einer sich parallel zur Achsrichtung erstreckenden Lauffläche (21) des Halters (4) anliegt und der über Verbindungselemente an einem am Drehantrieb (6) befestigten Mitnehmer (13) abgestützt ist.

6. Antriebseinheit nach Anspruch 5,
**dadurch gekennzeichnet,**
**dass** der Gleitschuh (14) an der flachen achsparallelen Lauffläche (21) gasgelagert, insbesondere luftgelagert, und magnetisch gegen diese vorgespannt ist.

7. Antriebseinheit nach Anspruch 6,
**dadurch gekennzeichnet,**
**dass** der Gleitschuh (14) mittels eines zur Drehachse parallelen biegsamen und tordierbaren Stabes (18) und eines zur Drehachse senkrechten Stiftes (19) am Mitnehmer (13) abgestützt ist, der fest mit einer Antriebswelle (9) des Drehantriebs (6) gekoppelt ist.

8. Antriebseinheit nach einem der vorhergehenden Ansprüche, **dadurch gekennzeichnet,**
**dass** der Drehantrieb (6) in der Achsrichtung (z) zwischen dem Halter (4) und dem Linearantrieb (5) angeordnet ist und dass der Stößel (25) durch den Drehantrieb (6) hindurchgeführt ist.

9. Antriebseinheit nach einem der vorhergehenden Ansprüche, **dadurch gekennzeichnet,**
**dass** der im wesentlichen zylindrische Halter (4) im Gehäuse (2) gasgelagert, insbesondere luftgelagert, ist.

10. Antriebseinheit nach einem der vorhergehenden Ansprüche, **dadurch gekennzeichnet,**
**dass** der hohle Stößel (25) an seinem vom Halter (4) abgewandten Ende an eine pneumatische Leitung angeschlossen ist.

11. Antriebseinheit nach Anspruch 10,
**dadurch gekennzeichnet,**
**dass** der Halter (4) an seinem vom Linearantrieb (5) abgewandten Ende einen in der Achsrichtung federnd abgestützten und mit einem auf einem Gaslager, insbesondere einem Luftlager, geführten Kolben (28) aufweist, an den das Funktionselement ansetzbar ist, und dass zwischen dem Kolben (28) und dem Stößelende ein in der Achsrichtung (z) nachgiebiger Faltenbalg (29) angeordnet ist.

12. Antriebseinheit nach Anspruch 11,
**dadurch gekennzeichnet,**
**dass** der gasgelagerte, insbesondere luftgelagerte, Kolben (28) pneumatisch mit dem Stößel (25) durch ein in diesen hineinragendes Saugrohr (30) verbunden ist.

## Claims

1. Drive unit for at least one movable functional element, in particular a placement head for handling an element configured e.g. as an electrical component part (1), with at least one holder (4), which is rotatable around an axis and linearly displaceable along the axis, for the functional element, wherein the drive unit has a rotary drive (6) and a linear drive (5) for the holder (4), wherein
• the holder (4) is coupled to movable parts of the linear drive (5) to be flexible transversely to the axis and kinematically fixed in the drive direction, so that the holder (4) is coupled to the linear drive (5) for transmission of an axial movement and is decoupled with respect to the axial position and
• the holder (4) is coupled to movable parts of the rotary drive (6) to be flexible transversely to the axis and kinematically fixed in the drive direction, so that the holder (4) is coupled to the rotary drive (6) for transmission of a rotation movement and is decoupled with respect to the axial position.

2. Drive unit according to claim 1, **characterised in that** stationary parts of the rotary drive (6) and the linear drive (5) are fixedly connected to a housing (2) of the actuation device.

3. Drive unit according to claim 2, **characterised in that** the linear drive (5) is coupled to the holder (4) by means of a flexible plunger (25) extending in the axial direction (z) and that the linear drive (5) is coupled to the plunger (25) by means of a pivot bearing (24).

4. Drive unit according to claim 2 or 3, **characterised in that** the rotary drive (6) is coupled to the holder (4) by means of a coupling (12).

5. Drive unit according to claim 4, **characterised in that** the coupling (12) has a sliding block (14) supported to be resiliently tiltable with respect to the rotational axis, which sliding block abuts against a running surface (21) of the holder (4) extending parallel to the axial direction and is supported on an entrainment device (13) fastened to the rotary drive (6) by means of connecting elements.

6. Drive unit according to claim 5, **characterised in that** the sliding block (14) is disposed on a gas bearing, in particular an air bearing, on the flat axis-parallel running surface (21) and is biased magnetically against this.

7. Drive unit according to claim 6, **characterised in that** the sliding block (14) is supported on the entrainment device (13), which is fixedly coupled to a drive shaft (9) of the rotary drive (6), by means of a flexible and twistable rod (18) parallel to the rotational axis and a pin (19) perpendicular to the rotational axis.

8. Drive unit according to one of the preceding claims, **characterised in that** the rotary drive (6) is arranged in the axial direction (z) between the holder (4) and the linear drive (5) and that the plunger (25) is guided through the rotary drive (6).

9. Drive unit according to one of the preceding claims, **characterised in that** the substantially cylindrical holder (4) is disposed on a gas bearing, in particular an air bearing, in the housing (2).

10. Drive unit according to one of the preceding claims, **characterised in that** the hollow plunger (25) is connected to a pneumatic line at its end remote from the holder (4).

11. Drive unit according to claim 10, **characterised in that** at its end remote from the linear drive (5) the holder (4) has a piston (28) resiliently supported in the axial direction and guided on a gas bearing, in particular an air bearing, onto which piston the functional element is attachable, and that a bellows member (29) flexible in the axial direction (z) is arranged between the piston (28) and the plunger end.

12. Drive unit according to claim 11, **characterised in that** the piston (28) arranged on a gas bearing, in particular an air bearing, is connected pneumatically to the plunger (25) by a suction pipe (30) projecting into this.

## Revendications

1. Unité d'entraînement pour au moins un élément fonctionnel mobile, en particulier une tête de chargement pour la manipulation d'un élément, réalisé par exemple sous forme de composant électrique (1), comprenant au moins un support (4), capable de rotation autour d'un axe et capable de translation linéaire le long de l'axe, pour l'élément fonctionnel, ladite unité d'entraînement comprenant un entraînement rotatif (6) et un entraînement linéaire (5) pour le support (4),
dans laquelle
- le support (4) est couplé avec des parties mobiles de l'entraînement linéaire (5) de manière souple perpendiculairement à l'axe et de manière cinématiquement ferme dans la direction d'entraînement, de sorte que le support (4) est couplé avec l'entraînement linéaire (5) pour la transmission d'un mouvement axial et est découplé pour ce qui concerne la situation de l'axe, et
- le support (4) est couplé avec des parties mobiles de l'entraînement rotatif (6) de manière souple perpendiculairement à l'axe et de manière cinématiquement ferme dans la direction d'entraînement, de sorte que le support (4) est couplé avec l'entraînement rotatif (6) pour la transmission d'un mouvement rotatif, et est découplé pour ce qui concerne la situation de l'axe.

2. Unité d'entraînement selon la revendication 1,
**caractérisée en ce que** les parties stationnaires de l'entraînement rotatif (6) et de l'entraînement linéaire (5) sont reliées solidairement avec un boîtier (2) du moyen d'actionnement.

3. Unité d'entraînement selon la revendication 2,
**caractérisée en ce que** l'entraînement linéaire (5) est couplé avec le support (4) via un poussoir flexible (25) s'étendant dans la direction de l'axe (z), et **en ce que** l'entraînement linéaire (5) est couplé avec le poussoir (25) via un palier rotatif (24).

4. Unité d'entraînement selon la revendication 2 ou 3,
**caractérisée en ce que** l'entraînement rotatif (6) est couplé avec le support (4) via un embrayage (12).

5. Unité d'entraînement selon la revendication 4,
**caractérisée en ce que** l'embrayage (12) comprend un patin coulissant (14) soutenu par rapport à l'axe de rotation de manière à pouvoir basculer avec effet élastique, qui est appliqué contre une surface de déplacement (21), s'étendant parallèlement à la direction de l'axe, du support (4), et est soutenu via des éléments de liaison sur un élément d'entraînement fixé sur l'entraînement rotatif (6).

6. Unité d'entraînement selon la revendication 5,
**caractérisée en ce que** le patin coulissant (14) est monté sur un coussin de gaz au niveau de la surface de déplacement plane (21) parallèle à l'axe, en particulier sur un coussin d'air, et est précontraint contre cette surface par voie magnétique.

7. Unité d'entraînement selon la revendication 6,
**caractérisée en ce que** le patin coulissant (14) est soutenu sur l'élément d'entraînement (13) au moyen d'un barreau (18) flexible parallèle à l'axe de rotation et susceptible d'être tordu, et d'une tige (19) perpendiculaire à l'axe de rotation, l'élément d'entraînement étant fermement couplé avec un arbre d'entraînement (9) de l'entraînement rotatif (6).

8. Unité d'entraînement selon l'une des revendications précédentes, **caractérisée en ce que** l'entraînement rotatif (6) est agencé en direction axiale (z) entre le support (4) et l'entraînement linéaire (5), et **en ce que** le poussoir (25) est passé à travers l'entraînement rotatif (6).

9. Unité d'entraînement selon l'une des revendications précédentes, **caractérisée en ce que** le support sensiblement cylindrique (4) est monté dans le boîtier au moyen d'un palier à gaz, en particulier d'un palier à air.

10. Unité d'entraînement selon l'une des revendications précédentes, **caractérisée en ce que** le poussoir creux (25) est raccordé à une conduite pneumatique à son extrémité détournée du support (4)

11. Unité d'entraînement selon la revendication 10,
**caractérisée en ce que** le support (4) comprend à son extrémité détournée de l'entraînement linéaire (5) un piston (28) soutenu par un ressort en direction axiale et guidé sur un palier à gaz, en particulier un palier à air, piston sur lequel l'élément fonctionnel peut être engagé, et **en ce qu'**un soufflet plissé (29) souple en direction axiale (z) est agencé entre le piston (28) et l'extrémité du poussoir.

12. Unité d'entraînement selon la revendication 11,
**caractérisée en ce que** le piston (28) monté sur un palier à gaz, en particulier un palier à air, est relié pneumatiquement au poussoir (25) via un tube d'aspiration (30) qui pénètre dans celui-ci.
